(19) **Europäisches Patentamt / European Patent Office / Office européen des brevets**

(11) **EP 3 991 213 B1**

(12) **FASCICULE DE BREVET EUROPEEN**

(45) Date de publication et mention
de la délivrance du brevet:
**28.05.2025 Bulletin 2025/22**

(21) Numéro de dépôt: **20734543.0**

(22) Date de dépôt: **25.06.2020**

(51) Classification Internationale des Brevets (IPC):
*H10H 20/01* (2025.01)  *H10H 20/813* (2025.01)
*H10H 20/818* (2025.01)  *H10H 20/819* (2025.01)
*H10H 20/824* (2025.01)  *H10H 29/14* (2025.01)
*H01L 25/075* (2006.01)

(52) Classification Coopérative des Brevets (CPC):
**B29C 45/14639; B29C 45/0055; H01L 25/0753;
H10H 20/013; H10H 20/813; H10H 20/818;
H10H 20/819; H10H 20/824; H10H 29/142;**
B29C 45/14811; B29C 2045/0058; B60R 16/0207;
H10H 20/0133; H10H 20/01335; H10H 20/0137;
(Cont.)

(86) Numéro de dépôt international:
**PCT/EP2020/067959**

(87) Numéro de publication internationale:
**WO 2020/260541 (30.12.2020 Gazette 2020/53)**

(54) **PROCEDE D'HOMOGENEISATION DE LA SECTION DE NANOFILS POUR DIODES ELECTROLUMINESCENTES**

VERFAHREN ZUR HOMOGENISIERUNG DES ABSCHNITTS DER NANODRÄHTE FÜR LEUCHTDIODEN

PROCESS FOR HOMOGENISATION OF THE NANOWIRE SECTION FOR LIGHT EMITTING DIODES

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **25.06.2019 FR 1906898**

(43) Date de publication de la demande:
**04.05.2022 Bulletin 2022/18**

(73) Titulaires:
• **Aledia**
**38130 Echirolles (FR)**
• **Commissariat à l'Energie Atomique et aux Energies
Alternatives
75015 Paris (FR)**
• **Université Grenoble Alpes
38400 Saint-Martin-d'Hères (FR)**

(72) Inventeurs:
• **DAUDIN, Bruno-Jules
38054 GRENOBLE CEDEX 9 (FR)**
• **CHIKHAOUI, Walf
38500 VOIRON (FR)**
• **GRUART, Marion
38120 SAINT-EGREVE (FR)**
• **GILET, Philippe
38470 TECHE (FR)**

(74) Mandataire: **Cabinet Beaumont
4, Place Robert Schuman
B.P. 1529
38025 Grenoble Cedex 1 (FR)**

(56) Documents cités:
EP-A1- 1 796 180      WO-A1-2019/002786
FR-A1- 3 044 470      US-A1- 2014 110 664
US-A1- 2016 365 480

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

(52) Classification Coopérative des Brevets (CPC):
(Cont.)H10H 20/825

**Description**

La présente demande de brevet revendique la priorité de la demande de brevet français FR19/06898.

Domaine technique

La présente invention concerne de façon générale les dispositifs optoélectroniques à diodes électroluminescentes comprenant des éléments semiconducteurs tridimensionnels, par exemple des microfils, des nanofils, des éléments coniques de taille micrométrique ou nanométrique, ou des éléments tronconiques de taille micrométrique ou nanométrique et les procédés de fabrication de tels dispositifs.

Technique antérieure

On considère ici plus particulièrement l'amélioration des dispositifs optoélectroniques à diodes électroluminescentes du type axial, comprenant une zone active formée au sommet de chaque élément tridimensionnel. On appelle zone active de la diode électroluminescente la région depuis laquelle est émise la majorité du rayonnement électromagnétique fourni par la diode électroluminescente.

Les éléments tridimensionnels considérés ici comprennent un matériau semiconducteur comportant majoritairement un élément du groupe III et un élément du groupe V (par exemple du nitrure de gallium GaN), appelé par la suite composé III-V. De tels dispositifs sont, par exemple, décrits dans le brevet US9728680.

Chaque zone active est prise en sandwich entre l'élément semiconducteur tridimensionnel associé, qui est généralement dopé d'un premier type de conductivité, et une couche semiconductrice du même composé III-V que l'élément semiconducteur et dopée du type de conductivité opposé.

Un exemple de procédé de fabrication du dispositif optoélectronique comprend la formation des éléments semiconducteurs tridimensionnels par dépôt chimique en phase vapeur aux organométalliques (MOCVD, sigle anglais pour Metal-Organic Chemical Vapor Deposition). Toutefois, il peut être difficile de contrôler avec précision le diamètre moyen des éléments semiconducteurs avec un tel procédé de croissance. De ce fait, un même dispositif optoélectronique peut comprendre des éléments semiconducteurs ayant des diamètres moyens différents. La longueur d'onde du rayonnement émis par la zone active de la diode électroluminescente peut dépendre du diamètre moyen de la zone active et donc du diamètre moyen de l'élément semiconducteur sur lequel la zone active est formée. Une dispersion non contrôlée en longueur d'onde des rayonnements émis par les diodes électroluminescentes peut alors être obtenue.

Les documents WO 2019/002786 A1, US 2014/110664 A1 et US 2016/365480 A1 décrivent chacun des procédés de fabrication des dispositifs optoélectroniques comprenant des diodes électroluminescentes (DEL).

Résumé de l'invention

Ainsi, un objet d'un mode de réalisation est de pallier au moins en partie les inconvénients des dispositifs optoélectroniques décrits précédemment et de leurs procédés de fabrication.

Un autre objet d'un mode de réalisation est de réduire la dispersion en longueur d'onde des rayonnements émis par les diodes électroluminescentes du dispositif optoélectronique.

Ainsi, un mode de réalisation prévoit un procédé de fabrication d'un dispositif optoélectronique comprenant des diodes électroluminescentes comprenant la formation d'éléments semiconducteurs tridimensionnels en un composé III-V comprenant chacun une portion inférieure et une portion supérieure, et, pour chaque élément semiconducteur, la formation d'une zone active recouvrant le sommet de la portion supérieure et la formation d'au moins une couche semiconductrice du composé III-V recouvrant la zone active. Les portions supérieures sont formées par dépôt sous phase vapeur à une pression inférieure à 1,33 mPa.

Selon un mode de réalisation, les portions inférieures sont formées par gravure sélective ou par croissance épitaxiale, de préférence par une technique de dépôt chimique en phase vapeur aux organométalliques, ou par épitaxie par jets moléculaires.

Selon l'invention, les portions supérieures sont formées par épitaxie par jets moléculaires.

Selon l'invention, pour chaque élément semiconducteur, la portion supérieure est évasée par rapport à la portion inférieure.

Selon l'invention, pour chaque élément semiconducteur, le sommet de la portion supérieure a une aire supérieure d'au moins 20 % par rapport à la section droite de la portion inférieure.

Selon l'invention, pour la formation des portions supérieures, le rapport III/V est compris entre 1,3 et 2.

Selon l'invention, pour la formation des portions supérieures, la température des portions supérieures est comprise entre 700°C et 850°C.

Selon un mode de réalisation, pour la formation des portions inférieures, le rapport III/V est compris entre 0,01 et 1.

Selon un mode de réalisation, pour la formation des portions inférieures, la température des portions inférieures est comprise entre 700°C et 850°C.

Selon un mode de réalisation, les zones actives sont formées par épitaxie par jets moléculaires.

Selon un mode de réalisation, les portions inférieures des éléments semiconducteurs tridimensionnels sont des microfils, des nanofils, des éléments coniques de taille micrométrique ou nanométrique, ou des éléments tronconiques de taille micrométrique ou nanométrique.

Selon un mode de réalisation, les zones actives sont les régions depuis lesquelles est émise la majorité du rayonnement électromagnétique fourni par les diodes électroluminescentes.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe, partielle et schématique, d'un exemple d'un dispositif optoélectronique à diodes électroluminescentes du type axial ;
la figure 2 est une vue en coupe, partielle et schématique, d'un mode de réalisation d'un dispositif optoélectronique à diodes électroluminescentes du type axial ;
la figure 3 illustre une étape d'un mode de réalisation d'un procédé de fabrication du dispositif optoélectronique représenté en figure 2 ;
la figure 4 illustre une autre étape du procédé ;
la figure 5 illustre une autre étape du procédé ;
la figure 6 représente des images obtenues par microscopie électronique à balayage de nanofils pour différentes conditions de croissance ;
la figure 7 est une courbe d'évolution du rapport entre le diamètre moyen d'un nanofil après élargissement et le diamètre moyen du nanofil avant élargissement en fonction du diamètre moyen du nanofil avant élargissement ;
la figure 8 représente une image obtenue par microscopie électronique à balayage d'un exemple de certains éléments de diodes électroluminescentes de type axial ayant chacune la structure illustrée en figure 1 ;
la figure 9 représente, en fonction de la longueur d'onde, les spectres des rayonnements émis par les zones actives représentées en figure 8 ;
la figure 10 représente une image obtenue par microscopie électronique à balayage d'un mode de réalisation de certains éléments de diodes électroluminescentes de type axial ayant chacune la structure illustrée en figure 2 ; et
la figure 11 représente, en fonction de la longueur d'onde, les spectres des rayonnements émis par les zones actives représentées à la figure 10.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés. En particulier, les moyens de commande des dispositifs optoélectroniques sont bien connus et ne sont pas décrits.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un dispositif optoélectronique dans une position normale d'utilisation.

Sauf précision contraire, les expressions "environ", "approximativement", "sensiblement", et "de l'ordre de" signifient à 10 % près, de préférence à 5 % près. En outre, on considère ici que les termes "isolant" et "conducteur" signifient respectivement "isolant électriquement" et "conducteur électriquement".

La présente invention concerne des dispositifs optoélectroniques comprenant des éléments semiconducteurs tridimensionnels, par exemple des microfils, des nanofils, des éléments coniques de taille micrométrique ou nanométrique, ou des éléments tronconiques de taille micrométrique ou nanométrique. Le terme "microfil", "nanofil", "élément conique" ou "élément tronconique" désigne une structure tridimensionnelle de forme allongée, par exemple cylindrique, conique ou tronconique, selon une direction privilégiée, appelée axe par la suite, dont au moins deux dimensions, appelées dimensions mineures, sont comprises entre 5 nm et 2,5 $\mu$m, de préférence entre 50 nm et 1 $\mu$m, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures, par exemple comprise entre 1 µm et 50 µm. En particulier, un élément conique ou tronconique peut être un élément conique circulaire ou tronconique circulaire ou un élément conique pyramidal ou tronconique pyramidal. Dans la suite de la description, des modes de réalisation sont décrits pour des dispositifs optoélectroniques comprenant des microfils ou des nanofils, appelés de façon générale fils. Toutefois, ces modes de réalisation peuvent être mis en oeuvre pour des éléments semiconducteurs autres que des microfils ou des nanofils, par exemple des éléments coniques ou tronconiques. Dans la suite de la description, on appelle diamètre moyen d'un fil le diamètre du disque de même surface que la section droite du fil. En outre, on appelle longueur d'onde centrale d'un rayonnement la longueur d'onde du rayonnement qui transporte le plus d'énergie.

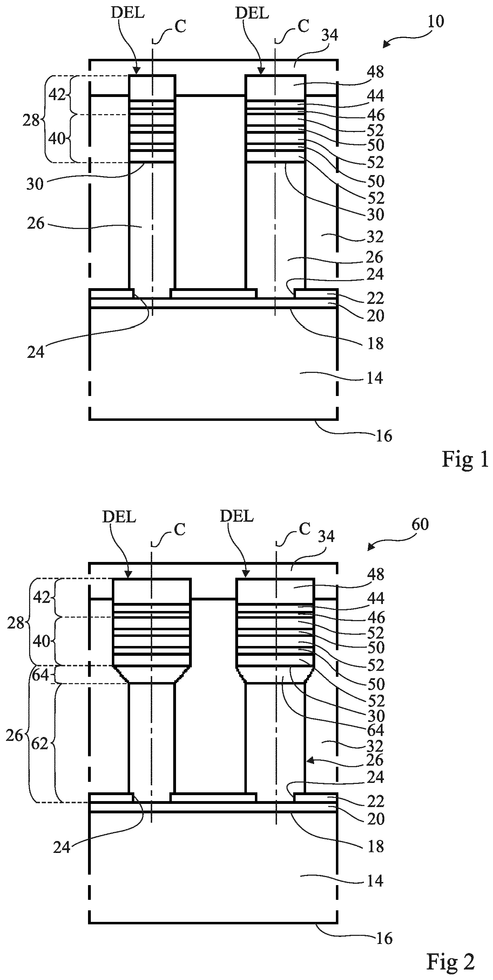

La figure 1 est une vue en coupe, partielle et schématique, d'un exemple d'un dispositif optoélectronique 10 à diodes électroluminescentes de type axial. Le dispositif optoélectronique 10 comprend du bas vers le haut en figure 1 :

- un substrat 14, par exemple un substrat semiconducteur, comprenant des faces parallèles 16 et 18, de préférence planes, la face 18 étant traitée pour promouvoir la croissance de fils. Ce traitement est représenté de façon schématique en figure 1 par une couche 20 de germination en un matériau favorisant la croissance des fils, sur la face 18 du substrat 14 ;

- une couche isolante 22 recouvrant la couche de germination 20 et comprenant des ouvertures 24 traversantes ;

- des fils 26 d'axes C parallèles, deux fils 26 étant représentés sur la figure 1 au moins en partie dopés d'un premier type de conductivité, par exemple dopés de type n ;

- pour chaque fil 26, une tête 28 recouvrant la face supérieure 30, également appelée sommet, du fil 26 ;

- une couche isolante 32 recouvrant les faces latérales des fils 26 et partiellement les faces latérales des têtes 28 ; et

- une couche d'électrode 34 recouvrant la couche isolante 32 et en contact avec les têtes 28.

Le dispositif optoélectronique 10 comprend une autre électrode, non représentée, pour polariser la base des fils 26.

Chaque tête 28 comprend du bas vers le haut en figure 1 :

- une zone active 40 recouvrant la face supérieure 30 du fil 26 ; et

- un empilement semiconducteur 42 recouvrant la zone active 40 et comprenant une couche semiconductrice 44 dopée d'un deuxième type de conductivité opposé à celui du fil 26, par exemple dopée de type p, et recouvrant la zone active 40.

L'ensemble formé par chaque fil 26 et la tête 28 associée correspond à une diode électroluminescente DEL en configuration axiale.

L'empilement semiconducteur 42 peut en outre comprendre une couche de blocage d'électrons 46 entre la zone active 40 et la couche semiconductrice 44 et une couche semiconductrice de liaison 48 recouvrant la couche semiconductrice 44 du côté opposé à la zone active 40, la couche de liaison 48 étant recouverte par la couche d'électrode 34 et au contact de la couche d'électrode 34. La couche de blocage d'électrons 46 est en contact avec la zone active 40 et la couche semiconductrice 44, et permet d'optimiser la présence des porteurs électriques dans la zone active 40. La couche de liaison 48 peut être du même matériau que la couche semiconductrice 44 et dopée du même type de conductivité que la couche semiconductrice 44 mais avec une concentration de dopants plus importante pour permettre la formation d'un contact ohmique entre la couche semiconductrice 44 et la couche d'électrode 34.

La zone active 40 est la zone de la diode électroluminescente DEL depuis laquelle est émise la majorité du rayonnement électromagnétique fourni par la diode électroluminescente DEL. Selon un exemple, la zone active 40 peut comporter des moyens de confinement. La zone active 40 peut comprendre au moins un puits quantique, comprenant une couche d'un matériau semiconducteur ayant une énergie de bande interdite inférieure à celle du fil 26 et de la couche semiconductrice 44, de préférence interposée entre deux couches barrières, améliorant ainsi le confinement des porteurs de charge, les couches barrières pouvant être du même matériau que le fil 26 et non intentionnellement dopées. La zone active 40 peut être formée d'un seul puits quantique ou d'une pluralité de puits quantiques. A titre d'exemple, en figure 1, on a représenté une alternance selon l'axe C de deux puits quantiques 50 et de trois couches barrières 52.

Un exemple de procédé de fabrication du dispositif optoélectronique 10 comprend la croissance des fils 26, des zones actives 40 et des empilements semiconducteurs 42 en mettant en oeuvre un procédé de croissance qui favorise une croissance cristalline selon l'axe C des fils 26. Le procédé de croissance des fils peut être un procédé du type dépôt chimique en phase vapeur aux organométalliques (MOCVD, acronyme anglais pour Metal-Organic Chemical Vapor Deposition), également connu sous le nom d'épitaxie organométallique en phase vapeur (ou MOVPE, acronyme anglais pour Metal-Organic Vapor Phase Epitaxy) . Le procédé MOCVD présente notamment l'avantage de vitesses de croissance élevées. La croissance de chaque fil 26 débute dans l'une des ouvertures 24 et continue en dehors de l'ouverture 24. Le diamètre moyen du fil 26 en dehors de l'ouverture 24 peut être différent du diamètre moyen de l'ouverture 24, et est en général supérieur au diamètre moyen de l'ouverture 24.

Un inconvénient est que le procédé MOCVD peut ne pas permettre de commander avec précision le diamètre moyen des fils 26. De ce fait, une dispersion importante des diamètres moyens des fils 26 du dispositif optoélectronique 10 peut être obtenue. Pour chaque diode électroluminescente DEL, le diamètre moyen de la zone active 40 dépend du diamètre moyen du fil 26 et peut être sensiblement égal au diamètre moyen du fil 26. Lorsque la zone active 40 comprend un puits quantique ou des puits quantiques, la longueur d'onde centrale du rayonnement émis par la zone active 40 de la diode électroluminescente DEL dépend notamment du diamètre moyen de la zone active 40 et donc du diamètre moyen du fil 26 sur lequel la zone active 40 est formée. Une dispersion importante des longueurs d'onde centrales des rayonnements émis par les diodes électroluminescentes peut alors être obtenue.

Les inventeurs ont mis en évidence que, après une première étape de croissance des fils 26 par MOCVD dans laquelle une portion inférieure de chaque fil est formée, et avant l'étape de formation des zones actives 40, en réalisant une deuxième étape de croissance des fils 26 par un procédé de croissance particulier, il est formé, pour chaque fil 26, une portion supérieure délimitant la face supérieure 30, sur laquelle sera formée la zone active 40 de telle sorte que la dispersion des diamètres moyens des surfaces supérieures est inférieure à la dispersion des diamètres moyens des portions inférieures des fils. Les procédés de croissance particuliers sont des procédés de croissance par dépôt sous phase vapeur sous vide à une pression inférieure à 1,33 mPa ($10^{-5}$ Torr), de préférence inférieure à 0,0133 mPa ($10^{-7}$ Torr), pour lesquels des jets moléculaires sont projetés sur les surfaces sur lesquelles une croissance cristalline est souhaitée. Il s'agit d'épitaxie par jets moléculaires (MBE, sigle anglais pour Molecular-Beam Epitaxy), notamment d'épitaxie par jets moléculaires assistée par plasma (PA-MBE, sigle anglais pour Plasma-Assisted Molecular-Beam Epitaxy) ou MBE assistée à l'ammoniac.

La figure 2 est une vue en coupe d'un mode de réalisation d'un dispositif optoélectronique 60. Le dispositif optoélectronique 60 comprend l'ensemble des éléments du dispositif optoélectronique 10 représenté en figure 1 à la différence que chaque fil 26 comprend une portion inférieure 62 de section droite sensiblement constante se prolongeant par une portion supérieure 64 qui, dans le présent mode de réalisation, a une forme évasée vers l'extérieur pour laquelle la section droite augmente selon l'axe C en s'éloignant du substrat 14. Selon un autre mode de réalisation, les fils 26 peuvent se répartir en premiers fils comprenant chacun la portion supérieure 64 évasée vers l'extérieur et en deuxièmes fils pour chacun desquels la portion supérieure 64 a une forme de pyramide tronquée dont la grande base repose sur la portion inférieure 62.

De préférence, pour chaque fil 26, la face supérieure 30 de la portion supérieure 64 du fil 26 correspond à une face sensiblement plane orthogonale à l'axe C du fil 26. L'aire de la face supérieure 30 est supérieure d'au moins 20 % à la section droite de la portion inférieure 62 du fil 26. La hauteur de la portion supérieure 64 de chaque fil 26 mesurée selon l'axe C peut être comprise entre 5 nm et 2 $\mu$m, de préférence entre 20 nm et 500 nm. La hauteur de la portion inférieure 62 de chaque fil 26 mesurée selon l'axe C peut être comprise entre 200 nm et 5 $\mu$m. Pour chaque fil 26, le diamètre moyen de la portion inférieure 62 du fil 26 peut être compris entre 50 nm et 10 $\mu$m, de préférence entre 100 nm et 2 $\mu$m, plus préférentiellement entre 100 nm et 1 $\mu$m. La section droite de la portion inférieure 62 du fil 26 peut avoir différentes formes, par exemple ovale, circulaire ou polygonale, en particulier rectangulaire, carrée ou hexagonale.

Les fils 26, les couches barrières 52, les couches semiconductrices 44 et les couches de liaison 48 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple le phosphore ou l'arsenic. De façon générale, les éléments dans le composé III-V peuvent être combinés avec différentes fractions molaires. Les composés III-V des fils 26 et des couches 44, 48 peuvent comprendre un dopant, par exemple du silicium (Si) qui est un dopant de type n pour les composés III-V ou du magnésium (Mg) qui est un dopant de type p pour les composés III-V.

Le matériau semiconducteur du puits quantique 50 ou des puits quantiques 50 de la zone active 40 peut comprendre le composé III-V du fil 26 et de la couche semiconductrice 44 dans lequel au moins un élément supplémentaire est incorporé. A titre d'exemple, dans le cas de fils 26 constitués de GaN, l'élément supplémentaire est par exemple l'indium (In). Le pourcentage atomique de l'élément supplémentaire est fonction des propriétés optiques souhaitées et du spectre d'émission de la diode électroluminescente DEL. Lorsque la portion supérieure 64 du fil 26 n'est pas intentionnellement dopée, celle-ci peut remplacer l'une des couches barrières 52 de la zone active 40.

La couche de blocage d'électrons 46 peut être formée en un alliage ternaire, par exemple en nitrure de gallium et d'aluminium (AlGaN) ou en nitrure d'indium et d'aluminium (AlInN).

Le substrat 14 peut correspondre à une structure monobloc ou correspondre à une couche recouvrant un support constitué d'un autre matériau. Le substrat 14 est de préférence un substrat semiconducteur, par exemple un substrat en silicium, en germanium, en carbure de silicium, en un composé III-V, tel que du GaN ou du GaAs, ou un substrat conducteur, par exemple un substrat métallique, notamment en cuivre, en titane, en molybdène, en un alliage à base de nickel ou en acier, ou un substrat en saphir. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouches de type silicium sur isolant, également appelée SOI (acronyme anglais pour Silicon On Insulator).

La couche de germination 20 est en un matériau favorisant la croissance des fils 26. A titre d'exemple, le matériau composant la couche de germination 20 peut être un nitrure, un carbure ou un borure d'un métal de transition de la colonne IV, V ou VI du tableau périodique des éléments ou une combinaison de ces composés. A titre d'exemple, la couche de germination 20 peut être en nitrure d'aluminium (AlN). La couche de germination 20 peut avoir une structure monocouche ou correspondre à un empilement de deux couches ou de plus de deux couches. Des exemples de matériau pour la couche de germination 20 sont décrits dans le brevet FR2997557.

La couche isolante 22 peut être en un matériau diélectrique, par exemple en oxyde de silicium ($SiO_2$) ou en nitrure de silicium ($Si_xN_y$, où x est environ égal à 3 et y est environ égal à 4, par exemple du $Si_3N_4$). A titre d'exemple, l'épaisseur de la couche isolante 22 est comprise entre 5 nm et 100 nm, par exemple égale à environ 30 nm. La couche isolante 22 peut avoir une structure monocouche ou correspondre à un empilement de deux couches ou de plus de deux couches.

La couche isolante 32 peut être en un matériau diélectrique, par exemple en oxyde de silicium ($SiO_2$) ou en nitrure de silicium ($Si_xN_y$, où x est environ égal à 3 et y est environ égal à 4, par exemple du $Si_3N_4$). La couche isolante 32 peut avoir une structure monocouche ou correspondre à un empilement de deux couches ou de plus de deux couches. A titre d'exemple, la couche isolante 32 peut être constituée d'un matériau polymère, d'un matériau inorganique ou d'une combinaison d'un matériau polymère et d'un matériau inorganique. A titre d'exemple, le matériau inorganique peut être de l'oxyde de titane ($TiO_2$) ou de l'oxyde d'aluminium ($Al_xO_y$, où x est environ égal à 2 et y est environ égal à 3, par exemple du $Al_2O_3$).

La couche d'électrode 34 est adaptée à polariser la zone active 40 recouvrant chaque fil 26 et à laisser passer le rayonnement électromagnétique émis par les diodes électroluminescentes DEL. Le matériau formant la couche d'électrode 34 peut être un matériau transparent et conducteur tel que de l'oxyde d'indium-étain (ou ITO, acronyme anglais pour Indium Tin Oxide), de l'oxyde de zinc dopé ou non à l'aluminium ou au gallium, ou du graphène. A titre d'exemple, la couche d'électrode 34 a une épaisseur comprise entre 5 nm et 200 nm, de préférence entre 20 nm et 50 nm.

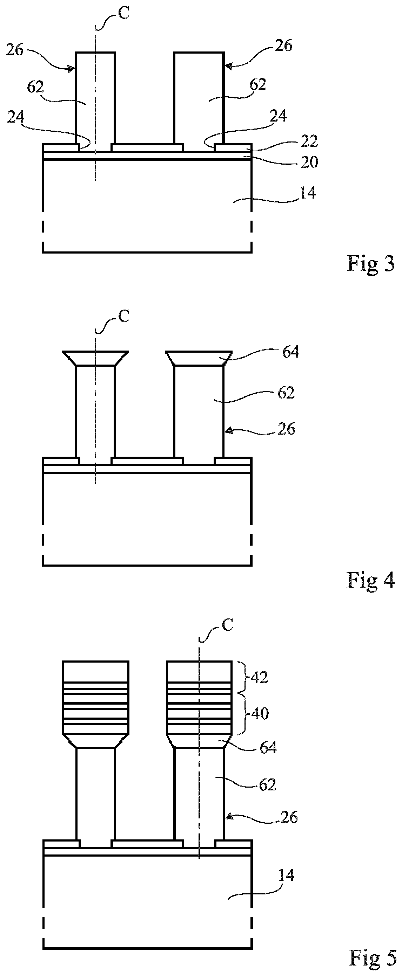

Les figures 3 à 5 sont des vues en coupe, partielles et schématiques, de la structure obtenue à des étapes successives d'un mode de réalisation d'un procédé de fabrication du dispositif optoélectronique 60 représenté en figure 2.

La figure 3 représente la structure obtenue après les étapes suivantes :

- formation sur le substrat 14 de la couche de germination 20 ;

- formation de la couche isolante 22 sur la couche de germination 20 ;

- formation des ouvertures 24 dans la couche isolante 22 pour exposer des portions de la couche de germination 20 aux emplacements souhaités des fils 26, le diamètre des ouvertures 24 correspondant sensiblement au diamètre moyen des fils 26 ; et

- croissance des portions inférieures 62 des fils 26 à partir de la couche de germination 20 dans les ouvertures 24.

La couche de germination 20 et la couche isolante 22 peuvent être formées par dépôt chimique en phase vapeur (CVD, sigle anglais pour Chemical Vapor Deposition), dépôt physique en phase vapeur (PVD, sigle anglais pour Physical Vapor Deposition) ou ALD.

Selon un mode de réalisation, la croissance des portions inférieures 62 des fils 26 est réalisée par MOCVD. A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac ($NH_3$), le tertiarybutylphoshine (TBT), l'arsine ($AsH_3$), ou le diméthylhydrazine asymétrique (UDMH). On appelle rapport III/V le rapport entre le flux de gaz du précurseur de l'élément du groupe III et le flux de gaz du précurseur de l'élément du groupe V. La pression dans le réacteur est comprise entre 50 torr (environ 7 kPa) et 500 torr (70 kPa). Les conditions de croissance dans le réacteur sont adaptées pour favoriser une croissance préférentielle de la portion inférieure 62 de chaque fil 26 selon son axe C. Cela signifie que la vitesse de croissance du fil 26 selon l'axe C est nettement supérieure, de préférence d'au moins un ordre de grandeur, à la vitesse de croissance du fil 26 selon une direction perpendiculaire à l'axe C. Selon un mode de réalisation, le rapport III/V est compris

7

entre 0,01 et 1, de préférence compris entre 0,01 et 0,1. La température dans le réacteur est, par exemple, comprise entre 900°C et 1150°C, de préférence entre 1000°C et 1100°C.

Selon un autre mode de réalisation, les portions inférieures 62 des fils 26 peuvent être formées par gravure dans une couche du composé III-V, notamment selon une technologie dite descendante (en anglais top-down).

La figure 4 représente la structure obtenue après la croissance des portions supérieures 64 des fils 26. Selon l'invention, la croissance des portions supérieures 64 des fils 26 est réalisée par MBE, de préférence PA-MBE. La pression dans le réacteur est inférieure à 1,33 mPa ($10^{-5}$ Torr), de préférence comprise entre $10^{-4}$ (environ 13,3 mPa) et $10^{-7}$ torr (environ 0,0133 mPa). Le rapport III/V, qui est alors le rapport entre le flux atomique de l'élément du groupe III et le flux atomique de l'élément du groupe V, est compris entre 0,8 et 2. Pour obtenir un élargissement de la portion supérieure 64 de chaque fil 26, le rapport III/V est supérieur à 1,3, notamment compris entre 1,3 et 2. Pour obtenir un élargissement de la portion supérieure 64 de chaque fil 26, la température dans le réacteur est de préférence comprise entre 750°C et 875°C, selon l'invention, la température est comprise entre 700°C et 850°C. La phase de croissance des portions supérieures 64 par PA-MBE peut entraîner la formation d'une coque de GaN sur les parois latérales des portions inférieures 62 des fils 26.

Si on appelle $\phi_{Ga}$ le flux atomique de l'élément du groupe III, $\phi_N$ le flux atomique de l'élément du groupe V, D le diamètre de la portion inférieure 62 du fil (que l'on considère de façon approximative cylindrique à base circulaire), $\theta$ l'angle d'incidence du flux atomique de l'élément du groupe III et du flux atomique de l'élément du groupe V sur la face supérieure 30 du fil 26, $n_{Ga}$ le nombre effectif d'atomes de l'élément du groupe III sur la face supérieure 30 et $n_N$ le nombre effectif d'atomes de l'élément du groupe V sur la face supérieure 30, et si on considère que la longueur de diffusion $\lambda$ de l'élément du groupe III sur les parois latérales des fils dépend seulement de la température, on peut déterminer la relation Math 1 suivante :

[Math 1]

$$\frac{n_{Ga}}{n_N} \sim k(T) \frac{\phi_{Ga}}{\phi_N} \left(1 + \frac{4\lambda}{D} \tan\theta\right)$$

où k(T) est un facteur tenant compte de la dépendance par rapport à la température de la désorption de l'élément du groupe III des parois latérales et de la face supérieure du fil 26.

En régime stabilisé, les dimensions de la face supérieure 30 sont fixées par le rapport $n_{Ga}/n_N$. Il apparaît donc, de façon avantageuse, que lorsque les portions supérieures 64 des fils 26 sont formées par PA-MBE, les dimensions de la face supérieure 30 de chaque portion supérieure 64, où est formée la zone active 40, évoluent vers des dimensions qui sont sensiblement indépendantes du diamètre moyen de la portion inférieure 62 du fil 26 depuis laquelle s'étend la portion supérieure 64 et qui dépendent du rapport III/V utilisé pour la formation de la portion supérieure 64. Ceci permet donc de commander avec précision les dimensions de la face supérieure 30 de la portion supérieure 64 et donc les dimensions latérales de la zone active 40. Ceci permet de compenser au moins partiellement la dispersion des diamètres moyens des portions inférieures 62 des fils 26 qui peuvent résulter du procédé de fabrication de ces portions inférieures 62. Si la croissance des portions supérieures 64 est interrompue avant d'atteindre le régime stabilité, les faces supérieures 30 des fils 26 peuvent ne pas avoir exactement les mêmes dimensions.

En outre, la longueur d'onde du rayonnement émis par un puits quantique dépend notamment de la proportion de l'élément supplémentaire du groupe III, par exemple l'indium, incorporé dans le composé ternaire du puits quantique. Cette proportion dépend elle-même des dimensions latérales de la zone active 40. De ce fait, un contrôle précis des dimensions latérales de la zone active 40 permet de contrôler avec précision la longueur d'onde du rayonnement émis par la zone active 40. La dispersion en longueurs d'onde des rayonnements émis par les diodes électroluminescentes peut donc être réduite.

La figure 5 représente la structure obtenue après la croissance des couches des zones actives 40 et des empilements semiconducteurs 42. Selon un mode de réalisation, la croissance des couches des zones actives 40 et des empilements semiconducteurs 42 est réalisée par PA-MBE. La pression dans le réacteur est comprise entre $10^{-4}$ et $10^{-7}$ torr. Pour la formation du puits quantique ou de chaque puits quantique, un élément supplémentaire du groupe III est ajouté dans le réacteur. Le rapport entre les flux atomiques des éléments du groupe III et le flux atomique de l'élément du groupe V pour la formation des zones actives 40 peut être compris entre 0,3 et 2. La température dans le réacteur est, par exemple, comprise entre 600°C et 850°C, de préférence entre 700°C et 800°C.

Pour la formation de la couche de blocage d'électrons 46, un élément supplémentaire du groupe III est ajouté dans le réacteur, le rapport III/V est de préférence proche de 1 et le rapport entre le flux atomique de l'élément supplémentaire et le flux atomique de l'élément du groupe V est compris entre 0,1 et 0,3. La couche de blocage d'électrons 46 peut être dopée de type p, par exemple avec du magnésium. Pour la formation de la couche de blocage d'électrons 46, la température dans le réacteur est, par exemple, comprise entre 600°C et 1000°C, de préférence entre 700°C et 950°C, plus préférentiellement entre 750°C et 900°C. Pour la formation de la couche semiconductrice 44 ou 48, le rapport III/V est de préférence inférieur à 1,3, notamment compris entre 1,1 et 1,3. Pour la formation de la couche semiconductrice 44 ou 48, la température dans le réacteur est, par exemple, comprise entre 700°C et 900°C, de préférence entre 750°C et 850°C.

Sur la figure 5, on a représenté chaque zone active 40 avec une section droite sensiblement constante selon l'axe C. A titre de variante, les conditions de croissance de la zone active 40 peuvent être sélectionnées de façon que la zone active 40 ait une forme de pyramide tronquée d'axe C avec une section droite qui diminue selon l'axe C en s'éloignant du substrat 14. Une telle forme peut être obtenue sans perte notable du volume du puits quantique ou des puits quantiques par rapport au cas où la section droite est constante. Une zone active 40 en forme de pyramide tronquée permet, de façon avantageuse, d'augmenter l'épaisseur de la couche semiconductrice 44 qui la recouvre et d'améliorer la passivation de la surface de la zone active 40.

Selon un autre mode de réalisation, la croissance des zones actives 40 et/ou des empilements semiconducteurs 42 est réalisée par MOCVD.

Des essais ont été réalisés. Pour ces essais, quatre fils NW1, NW2, NW3 et NW4 en GaN ayant des portions inférieures 62 de diamètres moyens différents ont été réalisés par MOCVD en utilisant des ouvertures 24 de diamètres différents. Les portions supérieures 64 en GaN des fils NW1, NW2, NW3 et NW4 ont été formées par PA-MBE. On appelle D0, ou diamètre initial, le diamètre moyen de la portion inférieure 62 du fil 26 mesuré au niveau du sommet de la portion inférieure 62 avant la phase de croissance par MBE de la portion supérieure 64. Le diamètre initial du fil NW1 était égal à 120 nm. Le diamètre initial du fil NW2 était égal à 180 nm. Le diamètre initial du fil NW3 était égal à 260 nm. Le diamètre initial du fil NW4 était égal à 480 nm. Pour la phase de croissance par MBE, différentes températures et différents rapports Ga/N ont été utilisés.

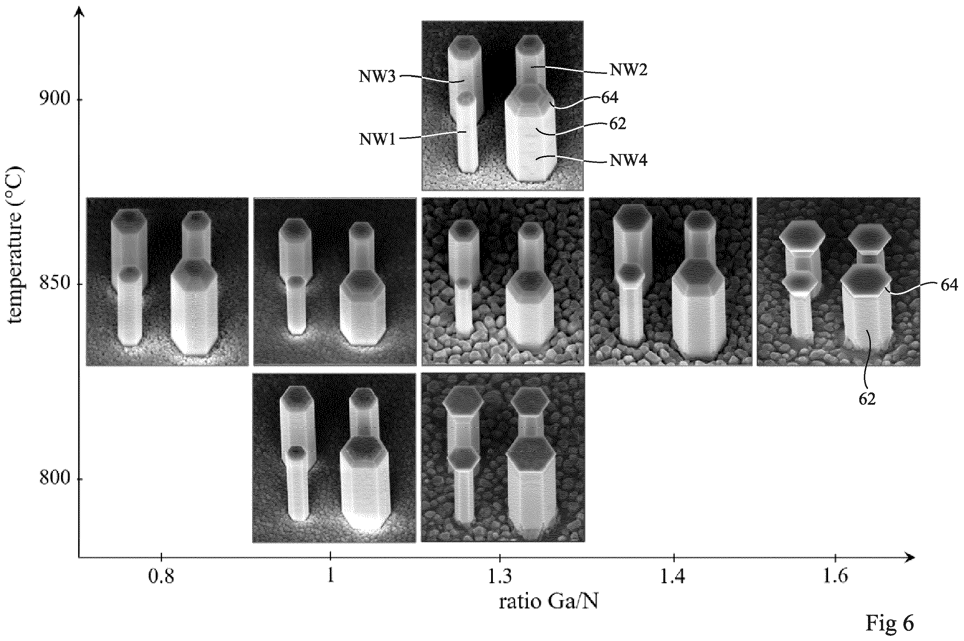

La figure 6 représente des images obtenues par microscopie électronique à balayage des fils NW1, NW2, NW3 et NW4 pour différentes températures de croissance et rapports Ga/N utilisés pour la MBE. Sur chaque image, le fil NW1 est situé en bas à gauche de l'image, le fil NW2 est situé en haut à droite de l'image, le fil NW3 est situé en haut à gauche de l'image et le fil NW4 est situé en bas à droite de l'image. Dans le cas de l'invention où une portion supérieure 64 de forme évasée est recherchée pour la majorité des fils NW1, NW2, NW3 et NW4, le rapport Ga/N est compris entre 1,3 et 2 et la température est comprise entre 700°C et 850°C.

Les résultats de mesures dans le cas où le rapport Ga/N était égal sensiblement à 1,6 et la température était égale sensiblement à 850°C sont rassemblés dans le tableau I ci-dessous.

[Table 1]

| Fil | D0 (nm) | D (nm) | D/D0 |
|-----|---------|--------|------|
| NW1 | 120 | 434,55 | 3,62 |
| NW2 | 180 | 520,70 | 2,89 |
| NW3 | 260 | 551,65 | 2,12 |
| NW4 | 480 | 626,48 | 1,46 |

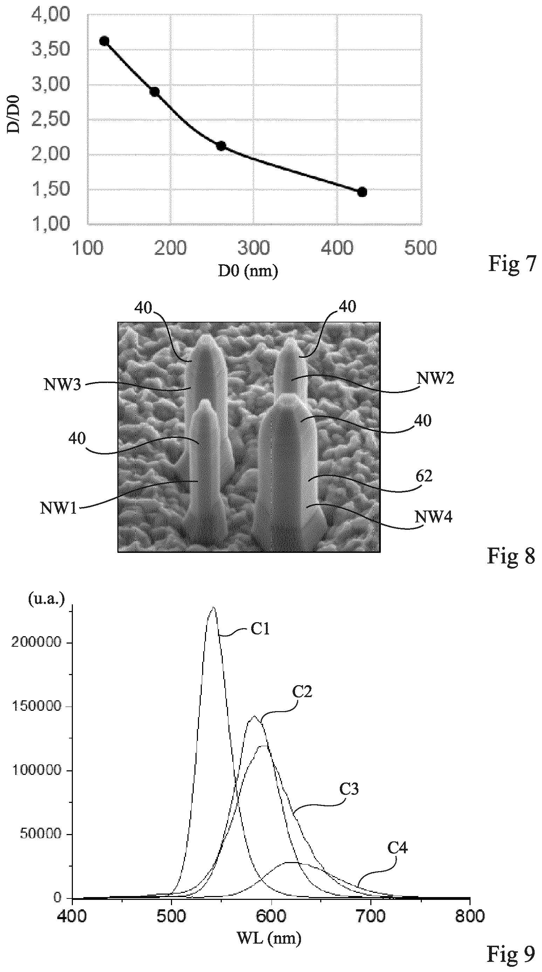

La figure 7 est une courbe d'évolution du rapport D/D0 entre le diamètre moyen D d'un fil après élargissement et le diamètre moyen initial D0 du nanofil avant élargissement en fonction du diamètre moyen initial D0 du nanofil avant élargissement.

La figure 8 représente une image obtenue par microscopie électronique à balayage des fils et des zones actives 40 de diodes électroluminescentes de type axial formées avec les fils NW1, NW2, NW3 et NW4 pour lesquels seule la portion inférieure 62 était présente. Les portions inférieures 62 des fils 26 étaient en GaN dopé de type n. Chaque zone active 40 comprenait un puits quantique unique en InGaN entre des couches barrières de GaN non dopé intentionnellement. Chaque empilement semiconducteur 42 comprenait une couche de blocage en AlGaN et une couche semiconductrice en GaN dopé de type p. Les portions inférieures 62 des fils ont été formées par PA-MBE avec un rapport Ga/N de 1,3 et une température de 900°C. Les puits quantiques en InGaN ont été formés par PA-MBE avec un rapport Ga+In/N de 1,6 et une température de 750°C. Les couches de blocage 46 en AlGaN ont été formées par PA-MBE avec un rapport Ga+Al/N de 1, un rapport Al/N de 0,2 et un rapport Ga/N de 0,8. Les couches semiconductrices 44 de GaN dopé de type p ont été formées par PA-MBE avec un rapport Ga/N de 0,8 et une température de 850°C.

La figure 9 représente des courbes d'évolution C1, C2, C3 et C4, en fonction de la longueur d'onde, du spectre des rayonnements émis par photoluminescence par les zones actives 40 de la figure 8 correspondant respectivement aux fils NW1, NW2, NW3 et NW4. L'écart entre la longueur d'onde centrale de la diode électroluminescente correspondant au fil NW1 et la longueur d'onde centrale de la diode électroluminescente correspondant au fil NW4 était d'environ 80 nm.

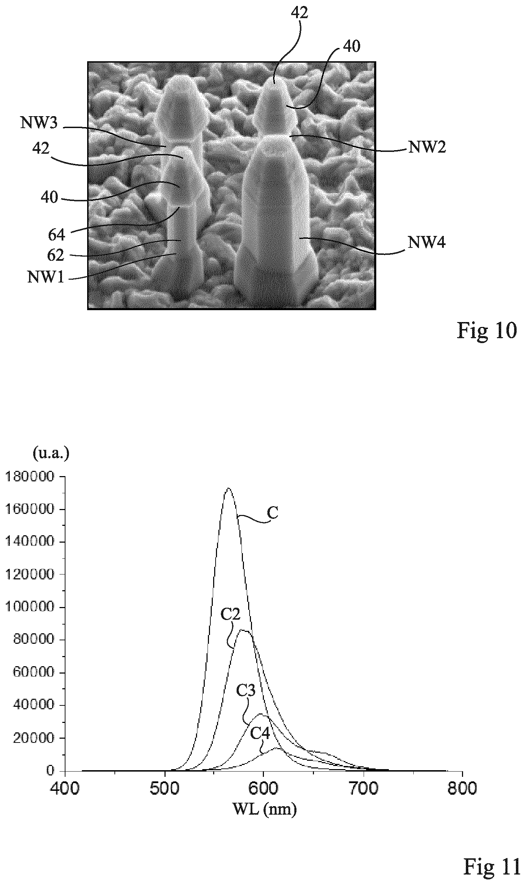

Les figures 10 et 11 sont des figures analogues respectivement aux figures 8 et 9 dans le cas où les fils NW1, NW2, NW3 et NW4 ont été formés comme cela a été décrit précédemment avec une portion supérieure 64 formée par PA-MBE. Les portions supérieures 64 des fils 26 étaient en GaN non intentionnellement dopé. Les portions supérieures 64 des fils 26 ont été formées par PA-MBE avec un rapport Ga/N de 1,6 et une température de 850°C pendant 10 minutes. L'écart entre la longueur d'onde centrale de la diode électroluminescente correspondant au fil NW1 et la longueur d'onde centrale de la diode électroluminescente correspondant au fil NW4 était d'environ 50 nm. La dispersion en longueur d'onde des zones actives représentées en figure 10 est inférieure à la dispersion obtenue avec les zones actives représentées en figure 8.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. Les modes de réalisation selon l'invention sont définis dans les revendications suivantes.

## Revendications

1. Procédé de fabrication d'un dispositif optoélectronique (60) comprenant des diodes électroluminescentes (DEL) comprenant la formation d'éléments semiconducteurs tridimensionnels (26) en un composé III-V comprenant chacun une portion inférieure (62) et une portion supérieure (64), et, pour chaque élément semiconducteur, la formation d'une zone active (40) recouvrant le sommet (30) de la portion supérieure et la formation d'au moins une couche semiconductrice (44) du composé III-V recouvrant la zone active, les portions supérieures sont formées par épitaxie par jets moléculaires à une pression inférieure à 1,33 mPa, pour chaque élément semiconducteur (26), la portion supérieure (64) est évasée par rapport à la portion inférieure (62), le sommet (30) de la portion supérieure (64) ayant une aire supérieure d'au moins 20 % par rapport à la section droite de la portion inférieure (62), pour la formation des portions supérieures (64), le rapport III/V est compris entre 1,3 et 2 et la température des portions supérieures est comprise entre 700°C et 850°C.

2. Procédé selon la revendication 1, dans lequel les portions inférieures (62) sont formées par gravure sélective ou par croissance épitaxiale, de préférence par une technique de dépôt chimique en phase vapeur aux organométalliques, ou par épitaxie par jets moléculaires.

3. Procédé selon la revendication 1 ou 2, dans lequel, pour la formation des portions inférieures (62), le rapport III/V est compris entre 0,01 et 1.

4. Procédé selon la revendication 3, dans lequel, pour la formation des portions inférieures (62), la température des portions inférieures est comprise entre 700°C et 850°C.

5. Procédé selon l'une quelconque des revendications 1 à 4, dans lequel les zones actives (40) sont formées par épitaxie par jets moléculaires.

6. Procédé selon l'une quelconque des revendications 1 à 5, dans lequel les portions inférieures (62) des éléments semiconducteurs tridimensionnels (26) sont des microfils, des nanofils, des éléments coniques de taille micrométrique ou nanométrique, ou des éléments tronconiques de taille micrométrique ou nanométrique.

7. Procédé selon l'une quelconque des revendications 1 à 6, dans lequel les zones actives (40) sont les régions depuis lesquelles est émise la majorité du rayonnement électromagnétique fourni par les diodes électroluminescentes (DEL).

## Patentansprüche

1. Verfahren zur Herstellung einer optoelektronischen Vorrichtung (60), die Leuchtdioden (DEL) aufweist, wobei das Verfahren Folgendes aufweist das Ausbilden von dreidimensionalen Halbleiterelementen (26), die aus einer III-V-Verbindung bestehen, wobei jedes einen unteren Abschnitt (62) und einen oberen Abschnitt (64) aufweist, und für jedes Halbleiterelement das Ausbilden eines aktiven Bereichs (40), der die Oberseite (30) des oberen Abschnitts bedeckt, und das Ausbilden mindestens einer Halbleiterschicht (44) der III-V-Verbindung, die den aktiven Bereich bedeckt, wobei die oberen Abschnitte durch Molekularstrahlepitaxie bei einem Druck von weniger als 1,33 mPa ausgebildet werden, wobei für jedes Halbleiterelement (26) der obere Abschnitt (64) in Bezug auf den unteren Abschnitt (62) aufgeweitet ist, wobei die Oberseite (30) des oberen Abschnitts (64) eine Fläche aufweist, die um mindestens 20 % größer ist als die Querschnittsfläche des unteren Abschnitts (62), wobei für das Ausbilden der oberen Abschnitte (64) das III/V-Verhältnis im Bereich von 1,3 bis 2 liegt und die Temperatur der oberen Abschnitte im Bereich von 700 °C bis 850 °C liegt.

2. Verfahren nach Anspruch 1, wobei die unteren Abschnitte (62) durch selektives Ätzen oder durch epitaktisches Wachstum, vorzugsweise durch eine metallorganische chemische Gasphasenabscheidung oder durch Molekularstrahlepitaxie, ausgebildet werden.

3. Verfahren nach Anspruch 1 oder 2, wobei für das Ausbilden der unteren Abschnitte (62) das III/V-Verhältnis im Bereich von 0,01 bis 1 liegt.

4. Verfahren nach Anspruch 3, wobei für das Ausbilden der unteren Abschnitte (62) die Temperatur der unteren Abschnitte im Bereich von 700 °C bis 850 °C liegt.

5. Verfahren nach einem der Ansprüche 1 bis 4, wobei die aktiven Bereiche (40) durch Molekularstrahlepitaxie gebildet werden.

6. Verfahren nach einem der Ansprüche 1 bis 5, wobei die unteren Abschnitte (62) der dreidimensionalen Halbleiterelemente (26) Mikrodrähte, Nanodrähte, konische Elemente im Mikrometer- oder Nanometerbereich oder kegelstumpfförmige Elemente im Mikrometer- oder Nanometerbereich sind.

7. Verfahren nach einem der Ansprüche 1 bis 6, wobei die aktiven Bereiche (40) die Regionen sind, von denen der größte Teil der von den Leuchtdioden (DEL) gelieferten elektromagnetischen Strahlung emittiert wird.

## Claims

1. Method of manufacturing an optoelectronic device (60) comprising light-emitting diodes (DEL) comprising the forming of three-dimensional semiconductor elements (26) made of a III-V compound, each comprising a lower portion (62) and an upper portion (64), and, for each semiconductor element, the forming of an active area (40) covering the top (30) of the upper portion and the forming of at least one semiconductor layer (44) of the III-V compound covering the active area, the upper portions are formed by molecular beam epitaxy at a pressure smaller than 1.33 mPa, for each semiconductor element (26), the upper portion (64) is flared with respect to the lower portion (62), the top (30) of the upper portion (64) having an area greater by at least 20% than the cross-section area of the lower portion (62), for the forming of the upper portions (64), the III/V ratio is in the range from 1.3 to 2 and the temperature of the upper portions is in the range from 700°C to 850°C.

2. Method according to claim 1, wherein the lower portions (62) are formed by selective etching or by epitaxial growth, preferably by a metal-organic chemical vapor deposition, or by molecular beam epitaxy.

3. Method according to claim 1 or 2, wherein, for the forming of the lower portions (62), the III/V ratio is in the range from 0.01 to 1.

4. Method according to claim 3, wherein, for the forming of the lower portions (62), the temperature of the lower portions is in the range from 700°C to 850°C.

5. Method according to any of claims 1 to 4, wherein the active areas (40) are formed by molecular beam epitaxy.

6. Method according to any of claims 1 to 5, wherein the lower portions (62) of the three-dimensional semiconductor elements (26) are microwires, nanowires, micrometer- or nanometer-range conical elements, or micrometer- or nanometer-range frustoconical elements.

7. Method according to any of claims 1 to 6, wherein the active areas (40) are the regions from which most of the electromagnetic radiation supplied by the light-emitting diodes (DEL) is emitted.

Fig 1

Fig 2

Fig 3

Fig 4

Fig 5

Fig 6

EP 3 991 213 B1

Fig 7

Fig 8

Fig 9

Fig 10

Fig 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1906898
- US 9728680 B
- WO 2019002786 A1
- US 2014110664 A1
- US 2016365480 A1
- FR 2997557